# EUROPÄISCHE PATENTANMELDUNG

(11) **EP 4 782 640 A1**
(43) Veröffentlichungstag der Anmeldung: **29.07.2026**
(21) Anmeldenummer: 26153723.7
(22) Anmeldetag: 23.01.2026
(51) Int. Cl.: E05F 15/619, E05F 15/616, H05K 1/14

(54) **SCHUBMITTELANTRIEB UND LEITERPLATTENGRUPPE FÜR SCHUBMITTELANTRIEB**

(30) Priorität: 23.01.2025 DE 202025100354 U
(71) Anmelder: Aumüller Aumatic GmbH, 86672 Thierhaupten (DE)
(72) Erfinder: Jayaprakash, Larun Prazad, 86672 Thierhaupten (DE); Kraemer, Julia, 86343 Königsbrunn (DE)
(74) Vertreter: ERNICKE Patent- und Rechtsanwälte PartmbB

(57) **Zusammenfassung**

Schubmittelantrieb (1) zum Öffnen und/oder Schließen eines Fensters mit einem Schubmittel (S), insbesondere einer Kette, umfassend ein Antriebsgehäuse (100), insbesondere zur Aufnahme einer Führung und eines Antriebs des Schubmittels (S) und eine Leiterplattengruppe (200), insbesondere zum Steuern und/oder zur Stromversorgung des Schubmittelantriebs (1). Die Leiterplattengruppe (200) ist hierbei ein vormontiertes Platinenmodul und umfasst einen Leiterplattenhauptabschnitt (210) und einen relativ zum Leiterplattenhauptabschnitt (210) beweglichen und elektrisch verbundenen Leiterplattennebenabschnitt (220).

## Beschreibung

Die Erfindung betrifft einen Schubmittelantrieb zum Öffnen und/oder Schließen einer Gebäudeklappe, wie eines Fensters, einer Lichtkuppel oder einer Belüftungs-/Entrauchungsklappe, mit einem Schubmittel (S), insbesondere einer Kette, und eine Leiterplattengruppe für den erfindungsgemäßen Schubmittelantrieb.

Schubmittelantriebe sind in verschiedenen Ausführungen bekannt und werden verwendet um Fensterflügel zu öffnen und zu schließen. Der Schubmittelantrieb umfasst ein Schubmittel, das mit einem Fensterflügel verbunden ist, um diesen zu bewegen. Ein Beispiel für ein Schubmittel ist eine (Schub-)Kette, die mit einem Kettenantrieb bewegbar ist.

Eine Leiterplatte kann ein Träger für elektronische Bauteile sein. Eine Leiterplatte kann der mechanischen Befestigung und der elektrischen Verbindung dienen. Leiterplatten können aus elektrisch isolierendem Material mit darauf haftenden, leitenden Verbindungen (Leiterbahnen) bestehen. Die Leiterplatte kann eine Steuereinheit zum Steuern des Schubmittelantriebs umfassen.

Die bekannten Leiterplatten erfordern eine aufwendige Montageund sind nicht optimal ausgebildet.

Es ist Aufgabe der vorliegenden Erfindung einen verbesserten Schubmittelantrieb und eine Leiterplattengruppe bereitzustellen, die eine einfache, und vorzugsweise im Wesentlichen werkzeuglose, Montage bei gleichzeitig hoher Stabilität des Schubmittelantriebs im montierten Zustand ermöglichen.

Die Erfindung löst diese Aufgabe mit den Merkmalen des Schubmittelantriebs und der Leiterplattengruppe gemäß den eigenständigen Ansprüchen.

Der erfindungsgemäße Schubmittelantrieb ist bevorzugt ein Kettenschubantrieb. Er umfasst bevorzugt eine erfindungsgemäße Leiterplattengruppe mit einem Leiterplattenhauptabschnitt und mindestens einem (separaten) Leiterplattennebenabschnitt. Der mindestens eine Leiterplattennebenabschnitt ist mit dem Leiterplattenhauptabschnitt elektrisch verbunden und zumindest im vormontierten Zustand relativ zum Leiterplattenhauptabschnitt beweglich. Der Leiterplattenhauptabschnitt und der Leiterplattennebenabschnitt können zumindest im montierten Zustand des Schubmittelantriebs je eine separate Leiterplatte umfassen oder sein. Bei Montage des Schubmittelantriebs kann eine Positionsfestlegung des Leiterplattenhauptabschnitts und des mindestens einen Leiterplattenebenabschnitts separat vorgenommen werden. Die Leiterplattengruppe kann auf beliebige Weise gefertigt und bereitgestellt sein. Sie kann beispielsweise einstückig gefertigt werden und danach in den Leiterplattenhauptabschnitt und den mindestens einen Leiterplattennebenabschnitt getrennt oder unterteilt werden oder einzeln gefertigt und danach zusammengefügt werden. Die Leiterplattengruppe ist bevorzugt ein vormontiertes Platinenmodul, in dem der Leiterplattenhauptabschnitt und der Leiterplattennebenabschnitt über einen beweglichen, insbesondere verformbaren, (d.h. flexiblen) Leiterplattenverbindungsabschnitt miteinander verbunden sind. Die Verbindung über den Leiterplattenverbindungsabschnitt ist bevorzugt dauerhaft. Die Verbindung über den Leiterplattenverbindungsabschnitt ist bevorzugt unlösbar. Die Verbindung über den Leiterplattenverbindungsabschnitt ist bevorzugt steckerfrei. An dem Leiterplattenhauptabschnitt ist bevorzugt eine Steuereinheit, insbesondere eine Eigensteuereinheit, zum Steuern des Schubmittelantriebs, insbesondere eines Antriebsmotors, angeordnet. Der Leiterplattennebenabschnitt umfasst bevorzugt einen Anschluss zum (elektrischen) Verbinden mit einem externen Objekt, insbesondere zum (elektrischen) Verbinden mit einer externen Stromversorgung und/oder mit einer externen Steuerung. Der Leiterplattenhauptabschnitt und der Leiterplattennebenabschnitt können bei der Montage am Antriebsgehäuse durch Einführung in eine Hauptöffnung und eine Nebenöffnung in besonders einfacher Weise positioniert und mechanisch befestigt werden, insbesondere ohne dass eine elektrische Verbindung zwischen dem Leiterplattenhauptabschnitt und dem Leiterplattennebenabschnitt separat hergestellt werden müsste. Dies vermeidet Kontaktierungsfehler und erleichtert den Montageprozess.

Die Leiterplattengruppe umfasst in einer bevorzugten Ausführung genau einen Leiterplattenhauptabschnitt und genau einen Leiterplattennebenabschnitt. Die Leiterplattengruppe umfasst in einer weiteren bevorzugten Ausführung genau einen Leiterplattenhauptabschnitt und genau zwei Leiterplattennebenabschnitte, nämlich insbesondere einen ersten Leiterplattennebenabschnitt und einen zweiten gegenüberliegenden Leiterplattennebenabschnitt.

Der Leiterplattenhauptabschnitt kann im montierten Zustand eine Hauptebene (HE) aufspannen. Der Leiterplattennebenabschnitt (220) kann eine (separate) Nebenebene (NE) aufspannen. Die Hauptebene und die Nebenebene können im montierten Zustand zueinander in einem vorgegebenen Winkel ausgerichtet sein. Insbesondere kann die Nebenebene quer zur Hauptebene ausgerichtet sein. Hierdurch kann der Anschluss an der Nebenebene in einer Soll-Lage positioniert sein, die das elektrische Verbinden der externen Komponente ermöglicht. Die Soll-Lage kann durch einen vorgegebenen Montagewinkel vorgegeben sein. Andererseits kann der Leiterplattennebenabschnitt vor der Montage und/oder während einer Wartung in einem anderen Winkel, insbesondere in einem Demontagewinkel angeordnet sein. Dies führt zu einer deutlich vereinfachten Herstellung der Leiterplattengruppe beziehungsweise des Platinenmoduls. Weiterhin erfordert die Leiterplattengruppe nur einen geringen Raumbedarf bei der Lagerung. Bei Wartungsarbeiten ist der Leiterplattennebenabschnitt bevorzugt verliersicher mit dem Leiterplattenhauptabschnitt verbunden.

Der Leiterplattenhauptabschnitt, insbesondere die Hauptebene (HE), und der Leiterplattennebenabschnitt, insbesondere die Nebenebene (NE), können in einem Winkel (W) anordenbar sein.

Der Winkel (W) kann variierbar, vorzugsweise werkzeuglos variierbar sein. Beispielsweise können der Leiterplattenhauptabschnitt, insbesondere die Hauptebene (HE), und der Leiterplattennebenabschnitt, insbesondere die Nebenebene (NE), händisch durch den Monteur gegeneinander biegbar sein. Beispielsweise kann die Leiterplattengruppe aus einem flexiblen biegsamen Material gebildet sein. Die Variierbarkeit des Winkels (W) kann in vorteilhafter Weise durch den Monteur genutzt werden, um die Form der Leiterplattengruppe an die Form des Antriebsgehäuses anzupassen, insbesondere händisch und/oder werkzeuglos, wodurch die Montage vereinfacht wird.

Der Winkel (W) kann variierbar sein zu einem Demontagewinkel (DW) hin und/oder zu einem Montagewinkel (MW) hin.

Der Demontagewinkel (DW) kann ein gestreckter Winkel sein. Er kann im Wesentlichen 0° (oder 180°) betragen, so dass der Leiterplattenhauptabschnitt, insbesondere die Hauptebene (HE), und der Leiterplattennebenabschnitt, insbesondere die Nebenebene (NE), im Wesentlichen parallel zueinander angeordnet sind. Bei der Herstellung der Leiterplattengruppe bzw des Platinenmoduls können der Leiterplattenhauptabschnitt und der Leiterplattennebenabschnitt gemeinsam aus einer übereinstimmenden Richtung bestückt werden, insbesondere in einer Normalrichtung zur Hauptebene. Beispielsweise kann die Leiterplattengruppe, insbesondere der Leiterplattenhauptabschnitt und der Leiterplattennebenabschnitt, als flacher flächiger Körper ausgebildet sein. Dadurch dass der Leiterplattenhauptabschnitt und der Leiterplattennebenabschnitt im Demontagewinkel (DW) im Wesentlichen in einer einzigen Ebene parallel angeordnet sind, kann beim Verstauen der Leiterplattengruppe im demontierten Zustand Platz gespart werden. Es können viele flache und flächige Leiterplattenkörper unter Einnahme von wenig Lagerraum gelagert werden.

Der Montagewinkel (MW) kann im Wesentlichen 90° betragen, so dass der Leiterplattenhauptabschnitt, insbesondere die Hauptebene (HE), und der Leiterplattennebenabschnitt, insbesondere die Nebenebene (NE), im Wesentlichen rechtwinklig zueinander angeordnet sind.

Das Antriebsgehäuse kann eine Hauptöffnung (HO) umfassen. Die die Hauptöffnung (HO) kann vollständig oder teilweise vom Leiterplattenhauptabschnitt überspannt, insbesondere verdeckt, sein. Die Hauptöffnung kann an einer Längsseite des Antriebsgehäuses vorgesehen sein.

Das Antriebsgehäuse kann eine Nebenöffnung (NO) umfassen. Die die Nebenöffnung (NO) kann vollständig oder teilweise vom Leiterplattennebenabschnitt überspannt, insbesondere verdeckt, sein. Die Nebenöffnung kann an einem Stirnende des Antriebsgehäuses vorgehen sein. Die Hauptöffnung ist bevorzugt deutlich größer als die Nebenöffnung.

Die Hauptöffnung (HO) und die Nebenöffnung (NO) können durch mehrere Wandungen des Antriebsgehäuses definiert sein. Die Hauptöffnung und die Nebenöffnung können winklig zueinander angeordnet sein, insbesondere rechtwinklig. Die Variierbarkeit des Winkels (W) kann in vorteilhafter Weise durch den Monteur genutzt werden, um die Form der Leiterplattengruppe an die Form des Antriebsgehäuses anzupassen, um die Hauptöffnung (HO) mit dem Leiterplattenhauptabschnitt und die Nebenöffnung (NO) mit dem Leiterplattennebenabschnitt zu überspannen.

Der Leiterplattenhauptabschnitt kann lösbar verbindbar sein, insbesondere werkzeuglos lösbar verbindbar, mit dem Antriebsgehäuse, insbesondere an der Hauptöffnung (HO) des Antriebsgehäuses, vorzugsweise mit einem ersten Verbinder, insbesondere mit einem ersten Steckverbinder.

Der Leiterplattennebenabschnitt kann lösbar verbindbar sein, insbesondere werkzeuglos lösbar verbindbar, mit dem Antriebsgehäuse, insbesondere an der Nebenöffnung (NO) des Antriebsgehäuses, vorzugsweise mit einem zweiten Verbinder, insbesondere mit einem zweiten Steckverbinder.

Folglich lassen sich der Leiterplattenhauptabschnitt und der Leiterplattennebenabschnitt separat, insbesondere werkzeuglos, mit dem Antriebsgehäuse verbinden. Der Monteur kann zunächst den Leiterplattenhauptabschnitt mit dem Antriebsgehäuse an der Hauptöffnung verbinden, um die Hauptöffnung teilweise oder vollständig zu überspannen. Anschließend kann der Monteur den Leiterplattennebenabschnitt mit dem Antriebsgehäuse an der Nebenöffnung verbinden, um die Nebenöffnung teilweise oder vollständig zu überspannen. Falls später notwendig zur Wartung, kann der Monteur die Verbindung zwischen Leiterplattennebenabschnitt und Antriebsgehäuse durch die Steckverbindung wieder werkzeuglos lösen, ohne die Verbindung zwischen Leiterplattenhauptabschnitt und Antriebsgehäuse lösen zu müssen. Das Innere des Schubmittelantriebs kann so für den Monteur zugänglich sein, ohne den gesamten Schubmittelantrieb, insbesondere die gesamte Leiterplattengruppe vom Antriebsgehäuse demontieren zu müssen. Nach Lösen der Verbindung zwischen Leiterplattennebenabschnitt und Antriebsgehäuse kann der Monteur den Winkel (W) wieder händisch variieren, insbesondere zum Demontagewinkel (DW) hin. Das Innere des Antriebsgehäuses ist über die Nebenöffnung zugänglich. Analog kann die Verbindung zwischen Leiterplattenhauptabschnitt und Antriebsgehäuse gelöst werden ohne Lösen der Verbindung zwischen Leiterplattenhauptabschnitt und Antriebsgehäuse, damit das Antriebsgehäuse über die Hauptöffnung zugänglich ist. Weiterhin können durch die Anordnung des Leiterplattenhauptabschnitts und des Leiterplattennebenabschnitts (bzw. der Leiterplattennebenabschnitte) Zugkräfte abgefangen werden, insbesondere im Betrieb des Schubmittelantriebs. Der Leiterplattenhauptabschnitt und der Leiterplattennebenabschnitt stützen sich durch ihre winklige Anordnung, insbesondere im Montagewinkel (MW), gegenseitig ab.

Der Leiterplattenhauptabschnitt, insbesondere die Hauptebene (HE), und der Leiterplattennebenabschnitt, insbesondere die Nebenebene (NE), können durch einen Leiterplattenverbindungsabschnitt verbunden sein. Der Leiterplattenverbindungsabschnitt kann beweglich, insbesondere verformbar, (d.h. flexibel formbar) sein, insbesondere zum werkzeuglosen Variieren des Winkels (W). Beispielsweise kann es sich beim Leiterplattenverbindungsabschnitt um eine flexible Leitung, insbesondere ein flexibles Leitungsband, insbesondere um ein flexibles Kabelband handeln. Die Leitung kann geeignet sein einen elektrischen Strom zwischen dem Leiterplattenhauptabschnitt und dem Leiterplattennebenabschnitt zu leiten. Bei dem Leiterplattenverbindungsabschnitt kann es sich auch um ein flexibles Material handeln, z.B. flexibler Kunststoff. An oder in dem Leiterplattenverbindungsabschnitt können Leitungen zum Stromtransport angeordnet sein.

Durch das Vorsehen des Leiterplattenverbindungsabschnitts können der Leiterplattenhauptabschnitt und der Leiterplattennebenabschnitt im Winkel (W) variierbar sein, ohne selbst flexibel formbar ausgebildet sein zu müssen. Folglich lassen sich die Herstellungskosten und die Beschädigungsgefahr der Leiterplattengruppe senken. Lediglich der Leiterplattenverbindungsabschnitt braucht zur Variierbarkeit des Winkels (W) eine Beweglichkeit, insbesondere Verformbarkeit, aufzuweisen.

Der Schubmittelantrieb, insbesondere die Leiterplattengruppe, insbesondere der Leiterplattenhauptabschnitt, kann eine Eigensteuereinheit zum Steuern des Schubmittelantriebs umfassen. Die Leiterplattengruppe, insbesondere der Leiterplattennebenabschnitt, kann einen Anschluss zum Verbinden der Eigensteuereinheit mit einer externen Stromversorgung und/oder mit einer externen Steuerung umfassen. Folglich kann das Antriebsgehäuse durch den Monteur bereits mit dem Leiterplattenhauptabschnitt verbunden werden. Anschließend kann der Monteur weitere Schritte zur Montage des Anschlusses am Leiterplattennebenabschnitt durchführen. Die Auftrennung der Leiterplattengruppe in Leiterplattenhauptabschnitt und Leiterplattennebenabschnitt erleichtert die Montage des Anschlusses.

Die vorgenannten Aspekte können jeweils in Alleinstellung oder in Kombination zur Lösung der Aufgabe genutzt werden. In den weiteren Unteransprüchen, Figuren und der Zeichnungsbeschreibung sind zusätzliche vorteilhafte Ausführungsformen des offenbarungsgemäßen Schubmittelantriebs und der offenbarungsgemäßen Leiterplattengruppe offenbart.

Alle Merkmale des Schubmittelantriebs mit Bezug auf die Leiterplattengruppe sind auch separate Merkmale der Leiterplattengruppe und umgekehrt.

### Zeichnungsbeschreibung

Die Offenbarung ist in den Zeichnungen beispielhaft und schematisch dargestellt. Es zeigen:
- Figur 1:: einen offenbarungsgemäßen Schubmittelantrieb (1) in perspektivischer Darstellung mit dem Antriebsgehäuse (100) und der Leiterplattengruppe (200) in einem nicht verbundenen Zustand mit Winkel (W) in Montagewinkel (MW)
- Figur 2:: einen offenbarungsgemäßen Schubmittelantrieb (1) in perspektivischer Darstellung mit dem Antriebsgehäuse (100) und der Leiterplattengruppe (200) in einem verbundenen Zustand
- Figur 3a:: einen offenbarungsgemäßen Schubmittelantrieb (1) in seitlicher Darstellung mit dem Antriebsgehäuse (100) und der Leiterplattengruppe (200) in einem verbundenen Zustand
- Figur 3b:: eine offenbarungsgemäßen Leiterplattengruppe (200) in seitlicher Darstellung mit Winkel (W) in Demontagewinkel (DW)

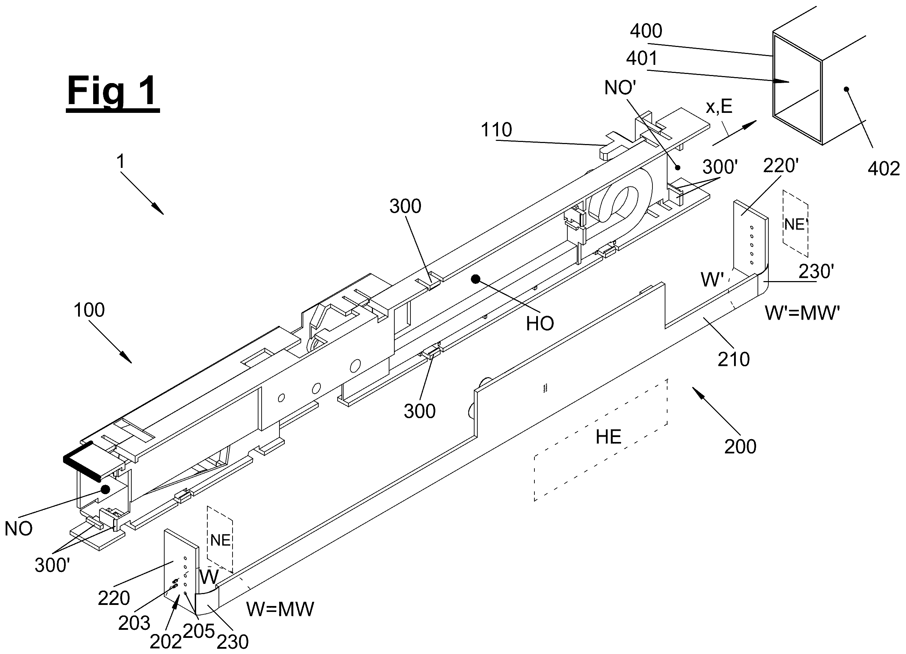

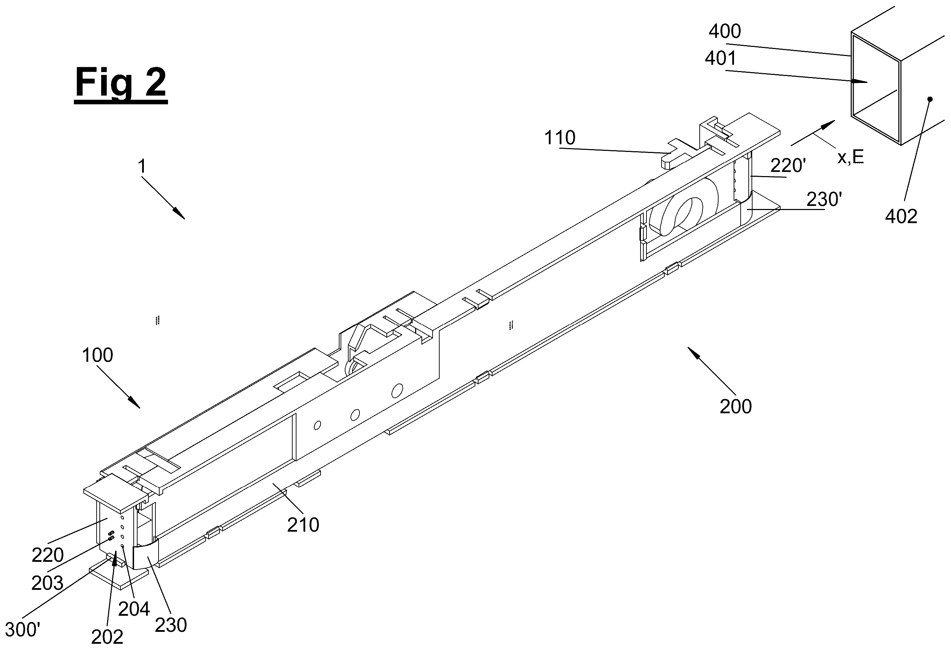

Die Figuren 1 bis 3 zeigen beispielhaft eine mögliche Ausführungsform des offenbarungsgemäßen Schubmittelantriebs (1) und der offenbarungsgemäßen Leiterplattengruppe (200). Die Leiterplattengruppe (200) kann auch insgesamt als Leiterplatte oder Leiterplattenmodul bezeichnet sein. In den dargestellten Figuren kann beispielhaft eine Kette (insbesondere eine Schubkette) als Schubmittel (S) verwendet werden, die durch einen Kettenantrieb als Fensteröffner angetrieben werden kann. Da es für das Verständnis der Offenbarung nicht notwendig ist, ist in den Figuren 1 bis 3 kein Schubmittel (S) dargestellt. Die gezeigte Ausführungsform ist beliebig kombinierbar mit anderen Arten von Schubmitteln und beliebigen Arten von Fensteröffnern, z.B. Linearantrieb, Hubspindelantrieb, etc.. In Betracht kommen jegliche Schubmittel (S), die eine translatorische Schub-und Ziehbewegung zum Öffnen und Schließen eines Fensterflügels ermöglichen.

Die Figuren 1, 2 und 3a zeigen einen beispielhaften offenbarungsgemäßen Schubmittelantrieb (1) zum Öffnen und Schließen eines Fensters mit einem Schubmittel (S), insbesondere einer Kette.

Der Schubmittelantrieb (1) umfasst:
- ein Antriebsgehäuse (100), insbesondere zur Aufnahme einer Führung und eines Antriebs des Schubmittels (S); und
- eine Leiterplattengruppe (200), insbesondere zum Steuern und/oder zur Stromversorgung des Schubmittelantriebs (1),
wobei die Leiterplattengruppe (200) umfasst:
- einen Leiterplattenhauptabschnitt (210), und
- mindestens einen Leiterplattennebenabschnitt (220), der relativ zum Leiterplattenhauptabschnitt (210) beweglich und elektrisch verbunden ist.

Das Antriebsgehäuse (100) kann bevorzugt ein Formkörper sein, insbesondere ein Kunststoff-Formkörper. Das Antriebsgehäuse ist bevorzugt durch Urformung gebildet, insbesondere durch Spritzguss. Es kann eine Mehrzahl von bevorzugten angepassten Aufnahmen für funktionale Bestandteile der Antriebstechnik aufweisen. Das Antriebsgehäuse (100) umfasst bevorzugt mehrere Rastaufnahmen für eine werkzeuglose positionierende Aufnahme der Leiterplattengruppe (200), insbesondere einerseits eine Rastaufnahme für den Leiterplattenhauptabschnitt (210) und/oder andererseits eine Rastaufnahme für den Leiterplattennebenabschnitt (220). Das Antriebsgehäuse (100) kann eine Schubmittelumlenkung (110) zum Umlenken des Schubmittels (S) umfassen, insbesondere zum Umlenken des Schubmittels (S) vom Schubmittelantrieb (1) zum Fenster hin. Der Schubmittelantrieb (1), insbesondere das Antriebsgehäuse (100) kann eine Führung umfassen, von der das Schubmittel (S) innerhalb des Schubmittelantriebs (1) geführt wird. Der Schubmittelantrieb (1), insbesondere das Antriebsgehäuse (100) kann einen Antrieb, insbesondere einen Antriebsmotor, umfassen, der das Schubmittel (S) antreibt. Das Antriebsgehäuse kann im montierten Zustand von einem weiteren, insbesondere rohrförmigen Schutzgehäuse (400) umgeben sein. Das Antriebsgehäuse (200) ist bevorzugt in einer geraden Richtung (x) entlang der (Haupt-) Erstreckung (E) des bevorzugt rohrförmigen Schutzgehäuses (400) in das Schutzgehäuse (400) einführbar. Im montierten Zustand ist der Leiterplattenhauptabschnitt (210) und/oder die Hauptebene (HE) bevorzugt entlang der Erstreckung (E) des Schutzgehäuses orientiert. Im montierten Zustand ist bevorzugt der (mindestens eine) Leiterplattennebenabschnitt (220) im Wesentlichen quer, insbesondere senkrecht zur Erstreckung (E) des Schutzgehäuses (400) orientiert. Im montierten Zustand überspannt der Leiterplattennebenabschnitt (220) bevorzugt eine Stirnöffnung (401) des Schutzgehäuses (401). Besonders bevorzugt überspannt ein erster Leiterplattennebenabschnitt (220) eine (erste) Stirnöffnung (401) des Schutzgehäuses (400) und ein zweiter Leiterplattennebenabschnitt (220') überspannt eine zweite Stirnöffnung, insbesondere eine gegenüberliegende Stirnöffnung des Schutzgehäuses.

Das Antriebsgehäuse (100) ist vorzugsweise durch mehrere Wandungen gebildet oder weist mehrere Wandungen auf (siehe Figur 1). Beispielsweise bilden die Wandungen einen länglichen quaderförmigen Körper (siehe Figur 1). Innerhalb der Wandungen können die Komponenten des Schubmittelantriebs (1) aufgenommen werden. Das Antriebsgehäuse (100) kann eine Hauptöffnung (HO) umfassen. Das Antriebsgehäuse (100) kann eine Nebenöffnung (NO) umfassen. Die Hauptöffnung (HO) ist im montierten Zustand bevorzugt in dem Schutzgehäuse (400) eingeschlossen. Die mindestens eine Nebenöffnung (NO) ist bevorzugt im montierten Zustand fluchtend zu einer Stirnöffnung (401) des Schutzgehäuses (400) angeordnet. Die Nebenöffnung (NO) kann durch die Stirnöffnung (401) des Schutzgehäuses (400) ringförmig umschlossen sein.

Im in den Figuren gezeigten Ausführungsbeispiel umfasst das Antriebsgehäuse (100) eine erste Nebenöffnung (NO) und eine zweite Nebenöffnung (NO'), die an gegenüberliegenden Seiten des quaderförmigen Antriebsgehäuses (100) angeordnet sind. Vorzugsweise handelt es sich bei der Nebenöffnung (NO) bzw. bei den Nebenöffnungen (NO, NO') um die seitlich im eingebauten Zustand am Fenster zugänglichen Seiten des Schubmittelantriebs (1), insbesondere des Antriebsgehäuses (100) und/oder des Schutzgehäuses (400). Diese seitliche(n) Nebenöffnung(en) können in vorteilhafterweise für den Monteur zu Wartungsarbeiten zugänglich sein, beispielsweise durch Lösen des/der Leiterplattennebenabschnitt(e) (220, 220'). Weiterhin kann bevorzugt an dem Leiterplattennebenabschnitt (220) mindestens ein Steckverbindungsanschluss und/oder Steckkontakt (203) vorgesehen sein, der für die Verbindung einer externen Komponente, insbesondere einem extern zuführbaren Steckverbinder vorgesehen ist. Die externe Komponente kann beispielsweise ein Kabel oder ein Steuermodul sein. Bevorzugt ist die externe Komponente an einer Stirnöffnung (401) des Schutzgehäuses (400) anordenbar, insbesondere einführbar.

Wie in den Figuren beispielhaft dargestellt kann die Hauptöffnung (HO) an einer Seite des Antriebsgehäuses (100) angeordnet sein, die senkrecht steht zu den Seiten der Nebenöffnung(en) (NO). Die Seite der Hauptöffnung (HO) kann ebenfalls im eingebauten Zustand am Fenster für einen Monteur zugänglich sein, beispielsweise durch (etwaiges Entfernen des Schutzgehäuses 400 und) vollständiges Lösen der Leiterplattengruppe (200) bzw. durch Lösen des Leiterplattenhauptabschnitts (210). Alternativ kann der Schubmittelantrieb (1) derart am Fenster montiert sein, dass die Hauptöffnung (HO) der Fensterseite zugewandt ist. In diesem Fall ist die Zugänglichkeit über die Nebenöffnung(en) (NO, NO') für Wartungsarbeiten noch wichtiger für eine leichtere Wartbarkeit des Schubmittelantriebs (1) und für eine leichtere Montage.

Die Figuren 1, 2,3a und 3b zeigen eine beispielhafte offenbarungsgemäße Leiterplattengruppe (200), insbesondere zum Steuern und/oder zur Stromversorgung des Schubmittelantriebs (1).

Die Hauptöffnung (HO) kann vollständig oder teilweise verdeckbar sein mit dem Leiterplattenhauptabschnitt (210). Die Nebenöffnung(en) (NO, NO') kann/können vollständig oder teilweise verdeckbar sein mit dem/den Leiterplattennebenabschnitt(en) (220, 220'). Wie in den Figuren dargestellt haben dazu die Öffnungen und die jeweiligen Leiterplattenabschnitte vorzugsweise eine komplementäre Form.

Wie in der in den Figuren beispielhaft gezeigten Ausführungsform gezeigt kann der Schubmittelantrieb (1) einen (ersten) Leiterplattennebenabschnitt (220) und einen (zweiten oder) weiteren Leiterplattennebenabschnitt (220') umfassen. Der Leiterplattenhauptabschnitt (210) ist bevorzugt mit dem mindestens einen Leiterplattennebenabschnitt (220, 220') zu einem vormontierten Platinenmodul integriert. Der Leiterplattenhauptabschnitt (210) ist bevorzugt mit dem mindestens einen Leiterplattennebenabschnitt (220, 220') über einen flexiblen Leiterplattenverbindungsabschnitt (230) verbunden. Besonders bevorzugt kann der Leiterplattenverbindungsabschnitt (230) einerseits mit dem Leiterplattenhauptabschnitt (210) und andererseits mit dem (mindestens einen) Leiterplattennebenabschnitt (220, 220') dauerhaft und/oder fest verbunden sein, insbesondere verlötet, verklebt oder verpresst sein. Alternativ sind beliebige andere feste Verbindungsarten möglich. Durch die Ausbildung als vormontiertes Platinenmodul und insbesondere die feste Verbindung wird eine besonders schnelle Montage des Schubmittelantriebs unterstützt. Es kann insbesondere auf ein zeitaufwendiges Positionieren und Schließen von Flachkabelanschlüssen verzichtet werden.

Der Leiterplattenhauptabschnitt (210) kann eine Hauptebene (HE) aufspannen.

Der Leiterplattennebenabschnitt (220) und der weitere Leiterplattennebenabschnitt (220') können jeweils eine Nebenebene (NE) und eine weitere Nebenebene (NE') aufspannen. Der Leiterplattennebenabschnitt (220) und der weitere Leiterplattennebenabschnitt (220') sind vorzugsweise an zwei gegenüberliegenden Seiten des Leiterplattenhauptabschnitts (210) angeordnet.

Der Leiterplattenhauptabschnitt (210), insbesondere die Hauptebene (HE), und der Leiterplattennebenabschnitt (220,220'), insbesondere die Nebenebene (NE, NE') können jeweils in einem Winkel (W, W') anordenbar sein. Der Winkel (W, W') kann variierbar sein, vorzugsweise werkzeuglos variierbar. Der Winkel (W, W') erstreckt sich bevorzugt zwischen einerseits der ebenen Erstreckung, insbesondere der Hauptebene (HE) des Leiterplattenhauptabschnitts (210) und andererseits einer bevorzugt ebenen Erstreckung, insbesondere der Nebenebene (NE) des Leiterplattennebenabschnitts (220, 220').

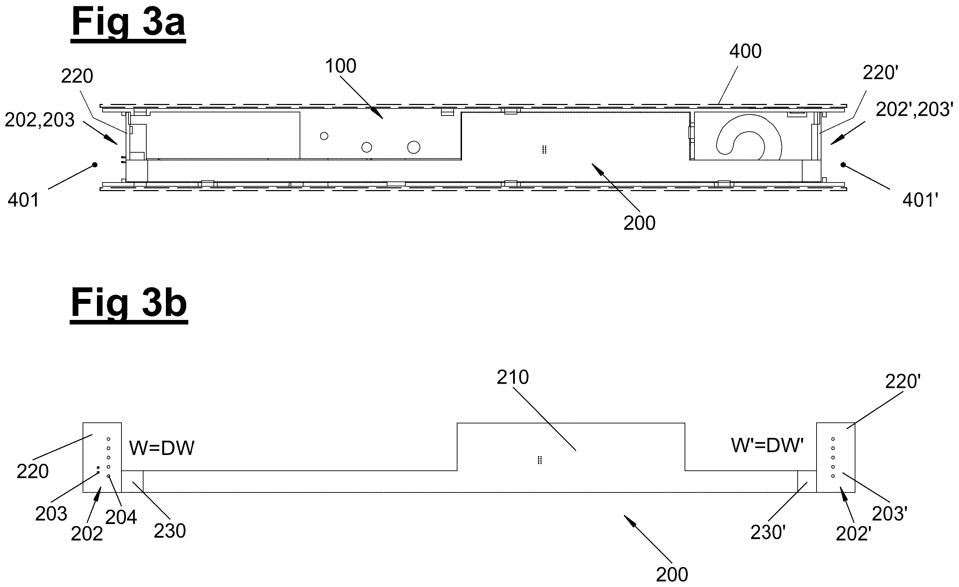

Der Winkel (W, W') kann variierbar sein. Der Winkel (W, W') kann bevorzugt in einem Bereich von mindestens 90° variierbar sein. Der Winkel (W, W') kann bevorzugte einerseits zu einem ersten Winkel hin, insbesondere einem Demontagewinkel (DW, DW') hin (siehe Figur 3b) und/oder andererseits zu einem zweiten Winkel hin, insbesondere zu einem Montagewinkel (MW, MW') hin variierbar sein (siehe Figur 1). Der Variationsbereich des Winkels (W, W') kann gleich oder größer einem Bereich sein, der durch den Demontagewinkel und den Montagewinkel begrenzt ist.

Wie in Figur 3b beispielhaft gezeigt kann der Demontagewinkel (DW, DW') im Wesentlichen ein gestreckter Winkel sein, insbesondere 0° (bzw. 180°) betragen, so dass der Leiterplattenhauptabschnitt (210), insbesondere die Hauptebene (HE), und der Leiterplattennebenabschnitt (220, 220'), insbesondere die Nebenebene (NE, NE'), im Wesentlichen parallel und/oder fluchtend zueinander angeordnet sind. Der erste Winkel, insbesondere der Demontagewinkel (DW, DW'), kann ein Winkel sein, der vor dem Montieren der Leiterplattengruppe, insbesondere des Platinenmoduls, am Antriebskörper vorliegt. Der zweite Winkel, insbesondere der Montagewinkel (MW, MW'), kann ein Winkel sein, der im Zuge der Montage des Schubmittelantriebs hergestellt wird und/oder im montierten Zustand vorliegt.

Wie in den Figuren 1,2 und 3a dargestellt, kann der Montagewinkel (MW, MW') im Wesentlichen 90° betragen, so dass der Leiterplattenhauptabschnitt (210), insbesondere die Hauptebene (HE), und der Leiterplattennebenabschnitt (220, 220'), insbesondere die Nebenebene (NE, NE'), im Wesentlichen rechtwinklig zueinander angeordnet sind. Folglich kann die Leiterplattengruppe / das Platinenmodul (100) im gezeigten Ausführungsbeispiel vorteilhaft genutzt werden, um (bei der Montage) beide Nebenöffnungen (NO, NO') separat abzudecken. Beide Nebenöffnungen (NO, NO') können separat zugänglich sein zur Montage und/oder für Wartungsarbeiten. Andererseits kann die Leiterplattengruppe / das Platinenmodul (100) im montierten Zustand einen Anschluss (202) und/oder einen Steckkontakt (203) an mindestens einer Stirnöffnung (401) des Schutzgehäuses (400) bereitstellen. Bevorzugt sind je ein Anschluss (202, 202') und/oder je ein Steckkontakt (203, 203') an je einem Leiterplattennebenabschnitt (220, 220') und somit an beiden Stirnöffnungen (401) angeordnet. Diese Anschlüsse (202, 202') und/oder Steckkontakt (203, 203') sind bevorzugt einerseits in elektrischer Verbindung mit dem Leiterplattenhauptabschnitt (220). Alternativ oder zusätzlich ist bevorzugt ein Anschluss (202) an einem ersten Leiterplattennebenabschnitt (220) verbunden mit einem Anschluss (202') an einem zweiten Leiterplattennebenabschnitt (220'). Alternativ oder zusätzlich ist bevorzugt ein Steckkontakt (203) an einem ersten Leiterplattennebenabschnitt (220) verbunden mit einem Steckkontakt (203') an einem zweiten Leiterplattennebenabschnitt (220'). Die Verbindung ist bevorzugt elektrisch. Sie kann eine Steuerverbindungen und/oder eine Betriebsstromverbindung umfassen. Die Verbindung kann eine Reihen- oder Parallelschaltung mehrerer Schubmittelantriebe unterstützen. Die Verbindung kann eine Kaskadenverbindung mehrerer Schubmittelantriebe unterstützen.

Wie in der in den Figuren beispielhaft gezeigten Ausführungsform weiterhin gezeigt kann der Schubmittelantrieb (1) einen Leiterplattenverbindungsabschnitt (230) und einen weiteren Leiterplattenverbindungsabschnitt (230') umfassen. Der Leiterplattenhauptabschnitt (210), insbesondere die Hauptebene (HE), und der Leiterplattennebenabschnitt (220, 220'), insbesondere die Nebenebene (NE, NE'), können durch den Leiterplattenverbindungsabschnitt (230, 230') verbunden sein. der Leiterplattenverbindungsabschnitt (230, 230') ist vorzugsweise flexibel verformbar zum werkzeuglosen Variieren des Winkels (W, W'). Der Leiterplattenverbindungsabschnitt (230) und der weitere Leiterplattenverbindungsabschnitt (230') sind vorzugsweise an zwei gegenüberliegenden Seiten des Leiterplattenhauptabschnitts (210) angeordnet.

Weitere nicht gezeigte Ausführungsformen mit weiteren Leiterplattenabschnitten und weiteren Leiterplattenverbindungsabschnitten in alternativen Anordnungen sind mit dem erfindungsgemäßen Schubmittelantrieb (1) und mit der erfindungsgemäßen Leiterplattengruppe (200) analog realisierbar.

Wie in den Figuren beispielhaft dargestellt kann der Leiterplattenhauptabschnitt (210) lösbar verbindbar sein, insbesondere werkzeuglos lösbar verbindbar, mit dem Antriebsgehäuse (100), insbesondere an der Hauptöffnung (HO) des Antriebsgehäuses (100), vorzugsweise mit einem ersten (mechanischen) Verbinder (300), insbesondere mit einem ersten Rast-, Klip- oder Steckverbinder (300'). Ein (mechanischer) Verbinder (300), insbesondere ein Rast-, Klip- oder Steckverbinder (300) kann im Zusammenhang mit dieser Offenbarung eine einrastbare, steckbare bzw. eine klipsbare Verbindung sein oder bereitstellen, beispielsweise durch das ineinander Stecken bzw. Klipsen von Plastikkomponenten. Alternative Ausführungsformen eines lösbaren (mechanischen) Verbinders (300) sind mit dem offenbarungsgemäßen Schubmittelantrieb (1) und mit der offenbarungsgemäßen Leiterplattengruppe (200) ebenfalls kombinierbar (z.B. Magnetverbinder, Schnellverschluss, Schraube, Bolzen, Gewinde).

Wie in den Figuren beispielhaft dargestellt kann der Leiterplattennebenabschnitt (220, 220') lösbar verbindbar sein, insbesondere werkzeuglos lösbar verbindbar, mit dem Antriebsgehäuse (100), insbesondere an der Nebenöffnung (NO, NO') des Antriebsgehäuses (100), vorzugsweise mit einem zweiten Verbinder (300), insbesondere mit einem zweiten Rast-, Klip- oder Steckverbinder (300').

In vorteilhafter Weise kann der Leiterplattennebenabschnitt (220, 220') lösbar verbindbar sein mit dem Antriebsgehäuse (100) durch Variieren des Winkels (W, W') zum Montagewinkel (MW, MW') hin. Wie in Figur 1 beispielhaft dargestellt kann der Winkel (W, W') vor dem Verbinden der Leiterplattengruppe (200) mit dem Antriebsgehäuse (100) zum Montagewinkel (MW, MW') variiert werden. Anschließend kann die gesamte Leiterplattengruppe (200) mit dem Antriebsgehäuse (100) verbunden werden durch lösbares Verbinden des Leiterplattenhauptabschnitts (210) und des Leiterplattennebenabschnitts (220, 220') jeweils mit dem Antriebsgehäuse (100). Hierzu kann der Leiterplattennebenabschnitt (220, 220') lösbar verbindbar sein mit dem Antriebsgehäuse (100) durch Einführen und/oder Einstecken des Leiterplattennebenabschnitts (220, 220') in die zweite Steckverbindung (300').

In einer nicht gezeigten alternativen Ausführungsform könnte auch zunächst die Leiterplattengruppe (200) im Demontagewinkel (DW) an dem Leiterplattenhauptabschnitt (210) mit dem Antriebsgehäuse (100), insbesondere an der Hauptöffnung (HO) verbunden werden. Anschließend könnte der Leiterplattennebenabschnitt (220, 220') durch Variieren des Winkels (W, W') zum Montagewinkel (MW, MW') hin mit dem Antriebsgehäuse (100), insbesondere an der Nebenöffnung (NO, NO') verbunden werden, beispielsweise durch Aufstecken bzw. Einklipsen des Leiterplattennebenabschnitts (220, 220') in den zweiten Verbinder (300'). Vor diesem Variieren des Winkels (W, W') zum Montagwinkel (MW, MW') hin sind die Nebenöffnungen (NO) in vorteilhafter Weise für den Monteur für Montage- bzw. Wartungsarbeiten zugänglich.

Der Schubmittelantrieb (1), insbesondere die Leiterplattengruppe (200), insbesondere der Leiterplattenhauptabschnitt (210), kann eine Eigensteuereinheit (201) zum Steuern des Schubmittelantriebs (1) umfassen (nicht in den Figuren dargestellt).

Wie in den Figuren beispielhaft dargestellt kann der Leiterplattennebenabschnitt (220, 220'), einen Anschluss (202) umfassen, zum Verbinden der Eigensteuereinheit (201) mit einer externen Stromversorgung und/oder mit einer externen Steuerung.

Der Schubmittelantrieb (1), insbesondere die Leiterplattengruppe (200), insbesondere der Leiterplattenhauptabschnitt (210), vorzugsweise die Eigensteuereinheit (201), kann mit der externen Stromversorgung und/oder mit der externen Steuerung über eine elektrische Leitung (205) verbindbar sein (nicht dargestellt in den Figuren).

Wie in den Figuren beispielhaft dargestellt kann der Anschluss (202) einen Steckkontakt (203) zum Verbinden des Schubmittelantriebs (1), insbesondere der Leiterplattengruppe (200), insbesondere des Leiterplattenhauptabschnitts (210), vorzugsweise der Eigensteuereinheit (201), vorzugsweise der Leitung (205), mit der externen Stromversorgung und/oder mit der externen Steuerung umfassen.

Wie in den Figuren beispielhaft dargestellt kann der Anschluss (202) eine Anschlussöffnung (204) zum Durchführen der Leitung (205) und zum Verbinden der Schubmittelantriebs (1), insbesondere der Leiterplattengruppe (200), insbesondere des Leiterplattenhauptabschnitts (210), vorzugsweise der Eigensteuereinheit (201), vorzugsweise der Leitung (205), mit der externen Stromversorgung und/oder mit der externen Steuerung umfassen.

Durch das Vorsehen des Anschlusses (202) an dem Leiterplattennebenabschnitt (220, 220') kann die vereinfachte Montage und Zugänglichkeit des Leiterplattennebenabschnitts (220,220'), insbesondere durch die Variierbarkeit des Winkels (W,W'), in vorteilhafter Weise genutzt werden zu einer vereinfachten Verkabelung des Schubmittelantriebs (1), insbesondere durch erleichterte Zugänglichkeit für den Monteur.

Die Leitung (205) kann durch oder am Leiterplattenverbindungsabschnitt (230, 230') zwischen dem Leiterplattenhauptabschnitt (210) und dem Leiterplattennebenabschnitt (220, 220') verlaufen. Folglich kann der Leiterplattenhauptabschnitt (210) mit dem Leiterplattennebenabschnitt (220,220') elektrisch leitend verbindbar sein zur Übertragung von Lastströmen und oder Datenströmen zur Steuerung.

Alternativ kann der Anschluss (202, 202') verbindbar sein mit weiteren Komponenten des Schubmittelantriebs (1), insbesondere mit weiteren im Antriebsgehäuse (100) aufgenommenen Komponenten des Schubmittelantriebs (1), wie z.B. der Führung des Schubmittels (S) und/oder dem Antrieb, insbesondere dem Motorantriebs, des Schubmittels (S).

Abwandlungen der Offenbarung sind in verschiedener Weise möglich. Die zu den jeweiligen Ausführungsbeispielen gezeigten, beschriebenen oder beanspruchten Merkmale können in beliebiger Weise miteinander kombiniert, gegeneinander ersetzt, ergänzt oder weggelassen werden.

Die Offenbarung umfasst weiterhin ein Montageverfahren zur Bereitstellung eines offenbarungsgemäßen Schubmittelantriebs (1), das zumindest die nachfolgenden Schritte umfasst. Bereitstellen eines Antriebsgehäuses (100) des Schubmittelantriebs, das bevorzugt an einer Längsseite eine Hauptöffnung (HO) und an einer anderen Seite, insbesondere an einer Stirnseite, eine Nebenöffnung (NO, NO') aufweist. Bereitstellen einer Leiterplattengruppe (200), die ein vormontiertes Platinenmodul ist, wobei die Leiterplattengruppe (200) einen Leiterplattenhauptabschnitt (210) sowie mindestens einen Leiterplattennebenabschnitt (220, 220') umfasst, die über einen flexiblen Leiterplattenverbindungsabschnitt (230) verbunden sind, insbesondere unlösbar und/oder steckerfrei verbunden sind. Befestigen, insbesondere werkzeugloses Verbinden, des Leiterplattenhauptabschnitts (210) an der Hauptöffnung. Befestigen, insbesondere werkzeugloses Verbinden, des Leiterplattennebenabschnitts (220, 220') an der Nebenöffnung (NO, NO'). Bevorzugt wird bei der Montage ein Winkel (W, W') zwischen dem Leiterplattenhauptabschnitt (210) und dem Leiterplattennebenabschnitt (220, 220') variiert, insbesondere werkzeuglos variiert.

Das Antriebsgehäuse (200) kann zusätzlich in einem bevorzugt rohrförmigen Schutzgehäuse (400) angeordnet werden, insbesondere durch Einschieben durch eine Stirnöffnung (401) des Schutzgehäuses. Die Einschubrichtung (x) verläuft bevorzugt entlang einer (Haupt-) Erstreckung (E) des rohrförmigen Schutzgehäuses (400).

### Bezugszeichen

- 1: Schubmittelantrieb
- 100: Antriebsgehäuse
- 110: Schubmittelumlenkung
- HO: Hauptöffnung
- NO: Nebenöffnung
- 200: Leiterplattengruppe / Platinenmodul
- 201: Eigensteuereinheit
- 202: Anschluss
- 203: Steckkontakt
- 204: Anschlussöffnung
- 205: Leitung
- 210: Leiterplattenhauptabschnitt
- HE: Hauptebene
- 220: Leiterplattennebenabschnitt
- NE: Nebenebene
- 230: Leiterplattenverbindungsabschnitt
- 300: Verbindung / Rast-, Klip- oder Steckverbindung (mechanisch)
- 400: Schutzgehäuse
- 401: Stirnöffnung
- 402: Seitenwand
- E: Haupterstreckung
- S: Schubmittel
- W: Winkel
- MW: Montagewinkel
- DW: Demontagewinkel

## Patentansprüche

1. Schubmittelantrieb (1) zum Öffnen und/oder Schließen eines Fensters mit einem Schubmittel (S), insbesondere einer Kette, umfassend:
- ein Antriebsgehäuse (100), insbesondere zur Aufnahme einer Führung und eines Antriebs des Schubmittels (S); und
- eine Leiterplattengruppe (200), insbesondere zum Steuern und/oder zur Stromversorgung des Schubmittelantriebs (1),
wobei die Leiterplattengruppe (200) ein vormontiertes Platinenmodul ist und umfasst:
- einen Leiterplattenhauptabschnitt (210), und
- einen relativ zum Leiterplattenhauptabschnitt (210) beweglichen und elektrisch verbundenen Leiterplattennebenabschnitt (220).

2. Schubmittelantrieb (1) gemäß Anspruch 1,
wobei der Leiterplattenhauptabschnitt (210) und der Leiterplattennebenabschnitt (220) durch einen beweglichen, insbesondere verformbaren, Leiterplattenverbindungsabschnitt (230) verbunden sind, insbesondere unlösbar und/oder steckerfrei verbunden sind, und/oder
wobei der Leiterplattenhauptabschnitt (220) eine Hauptebene (HE) aufspannt, und/oder
wobei der Leiterplattennebenabschnitt (220) eine separate Nebenebene (NE) aufspannt.

3. Schubmittelantrieb (1) gemäß Anspruch 1 oder 2,
wobei der Leiterplattenhauptabschnitt (210), insbesondere die Hauptebene (HE), und der Leiterplattennebenabschnitt (220), insbesondere die Nebenebene (NE), in einem Winkel (W) zueinander anordenbar sind, insbesondere im montierten Zustand des Schubmittelantriebs (1) angeordnet sind, wobei insbesondere, zumindest während der Montage des Schubmittelantriebs (1), der Winkel (W) variierbar ist, vorzugsweise werkzeuglos variierbar.

4. Schubmittelantrieb (1) gemäß einem der vorhergehenden Ansprüche, wobei der Winkel (W) zu einem Demontagewinkel (DW) hin und/oder zu einem Montagewinkel (MW) hin variierbar ist, wobei insbesondere
- der Demontagewinkel (DW) im Wesentlichen 0° beträgt, so dass der Leiterplattenhauptabschnitt (210) und der Leiterplattennebenabschnitt (220) im Wesentlichen parallel, insbesondere koplanar, zueinander angeordnet sind, und/oder
- der Montagewinkel (MW) im Wesentlichen 90° beträgt, so dass der Leiterplattenhauptabschnitt (210) und der Leiterplattennebenabschnitt (220) im Wesentlichen rechtwinklig zueinander angeordnet sind.

5. Schubmittelantrieb (1) gemäß einem der vorhergehenden Ansprüche, wobei der Leiterplattenhauptabschnitt (210) bei der Montage des Schubmittelantriebs (1) mit dem Antriebsgehäuse (100) lösbar verbindbar ist, insbesondere werkzeuglos lösbar verbindbar, und wobei insbesondere das Antriebsgehäuse (100) eine Hauptöffnung (HO) umfasst und der Leiterplattenhauptabschnitt (210) an der Hauptöffnung (HO) des Antriebsgehäuses (100) lösbar verbindbar ist, vorzugsweise mit einem ersten Verbinder (300), insbesondere mit einem ersten Rast-, Klip- oder Steckverbinder (300).

6. Schubmittelantrieb (1) gemäß einem der vorhergehenden Ansprüche, wobei das Schutzgehäuse (400) und/oder das Antriebsgehäuse (100) eine Nebenöffnung (NO) umfasst, die insbesondere an einem Stirnende angeordnet ist, wobei optional der Leiterplattennebenabschnitt (220) die Nebenöffnung (NO) vollständig oder teilweise überspannend anordenbar ist.

7. Schubmittelantrieb (1) gemäß einem der vorhergehenden Ansprüche, wobei der Leiterplattennebenabschnitt (220) lösbar verbindbar ist, insbesondere werkzeuglos lösbar verbindbar, mit dem Antriebsgehäuse (100), insbesondere an der Nebenöffnung (NO), vorzugsweise mit einem zweiten Verbinder (300), insbesondere mit einem zweiten Rast-, Klip- oder Steckverbinder (300').

8. Schubmittelantrieb (1) gemäß einem der vorhergehenden Ansprüche, wobei der Leiterplattennebenabschnitt (220) lösbar verbindbar ist mit dem Antriebsgehäuse (100) durch Variieren des Winkels (W) zum Montagewinkel (MW) hin, und/oder durch Einführen und/oder Einstecken des Leiterplattennebenabschnitts (220) in die zweite Rast-, Klip- oder Steckverbindung (300').

9. Schubmittelantrieb (1) gemäß einem der vorhergehenden Ansprüche, wobei der Schubmittelantrieb (1), insbesondere die Leiterplattengruppe (200), insbesondere der Leiterplattenhauptabschnitt (210), eine Eigensteuereinheit (201) zum Steuern des Schubmittelantriebs (1) umfasst.

10. Schubmittelantrieb (1) gemäß einem der vorhergehenden Ansprüche, wobei die Leiterplattengruppe (200), insbesondere der Leiterplattennebenabschnitt (220), einen Anschluss (202) umfasst, zum Verbinden der Leiterplattengruppe (200), insbesondere der Eigensteuereinheit (201), mit einer externen Stromversorgung und/oder mit einer externen Steuerung.

11. Schubmittelantrieb (1) gemäß einem der vorhergehenden Ansprüche, wobei der Schubmittelantrieb (1), insbesondere die Leiterplattengruppe (200), insbesondere der Leiterplattenhauptabschnitt (210), vorzugsweise die Eigensteuereinheit (201), mit der externen Stromversorgung und/oder mit der externen Steuerung über eine elektrische Leitung (205) verbindbar ist, und/oder wobei der Anschluss (202) einen Steckkontakt (203) zum Verbinden der Leiterplattengruppe (200), insbesondere des Leiterplattenhauptabschnitts (210), vorzugsweise der Eigensteuereinheit (201), vorzugsweise der Leitung (205), mit der externen Stromversorgung und/oder mit der externen Steuerung umfasst.

12. Schubmittelantrieb (1) gemäß einem der vorhergehenden Ansprüche, wobei die Leitung (205) durch oder am Leiterplattenverbindungsabschnitt (230) zwischen dem Leiterplattenhauptabschnitt (210) und dem Leiterplattennebenabschnitt (220) verläuft.

13. Schubmittelantrieb (1) gemäß einem der vorhergehenden Ansprüche, wobei der Schubmittelantrieb (1), insbesondere die Leiterplattengruppe (200), einen weiteren Leiterplattennebenabschnitt (220') gemäß einem der vorherigen Ansprüche umfasst, und/oder wobei der Schubmittelantrieb (1), insbesondere die Leiterplattengruppe (200), einen weiteren Leiterplattenverbindungsabschnitt (230') gemäß einem der vorherigen Ansprüche umfasst.

14. Schubmittelantrieb (1) gemäß einem der vorhergehenden Ansprüche, wobei der Leiterplattenhauptabschnitt (210) und der weitere Leiterplattennebenabschnitt (220') durch den weiteren Leiterplattenverbindungsabschnitt (230') verbunden sind, und/oder wobei der Leiterplattennebenabschnitt (220) und der weitere Leiterplattennebenabschnitt (220') an zwei gegenüberliegenden Seiten des Leiterplattenhauptabschnitts (210) angeordnet sind und/oder wobei der Leiterplattenverbindungsabschnitt (230) und der weitere Leiterplattenverbindungsabschnitt (230') an zwei gegenüberliegenden Seiten des Leiterplattenhauptabschnitts (210) angeordnet sind.

15. Leiterplattengruppe für einen Schubmittelantrieb (1) gemäß einem der vorhergehenden Ansprüche, wobei die Leiterplattengruppe (200) ein vormontiertes Platinenmodul ist, **dadurch gekennzeichnet, dass** die Leiterplattengruppe (200) einen Leiterplattenhauptabschnitt (210) sowie mindestens einen relativ zum Leiterplattenhauptabschnitt (210) beweglichen Leiterplattennebenabschnitt (220, 220') umfasst, die über einen beweglichen, insbesondere verformbaren, Leiterplattenverbindungsabschnitt (230) verbunden sind, wobei der Leiterplattenhauptabschnitt (210) eine Eigensteuereinheit (201) zum Steuern des Schubmittelantriebs (1) umfasst und der Leiterplattennebenabschnitt (220) einen Anschluss (202) zum elektrischen Verbinden mit einem externen Objekt umfasst, insbesondere zum Verbinden der Eigensteuereinheit (201) mit einer externen Stromversorgung und/oder mit einer externen Steuerung, und wobei insbesondere der Leiterplattenhauptabschnitt (210) und der Leiterplattennebenabschnitt (220) in einem variierbaren Winkel (W, W') zueinander anordenbar sind.
